# EUROPEAN PATENT SPECIFICATION

(11) **EP 3 104 283 B1**
(45) Date of publication and mention of the grant of the patent: **20.06.2018**
(21) Application number: 16170049.7
(22) Date of filing: 18.05.2016
(51) Int. Cl.: G06F 17/30

(54) **HARDWARE PROGRAMMABLE DEVICE WITH INTEGRATED SEARCH ENGINE**
PROGRAMMIERBARE HARDWAREVORRICHTUNG MIT INTEGRIERTER SUCHMASCHINE
DISPOSITIF MATÉRIEL PROGRAMMABLE AVEC UN MOTEUR DE RECHERCHE INTÉGRÉ

(30) Priority: 08.06.2015 US 201514733662
(43) Date of publication of application: 14.12.2016
(73) Proprietor: Altera Corporation, San Jose, CA 95134 (US)
(72) Inventor: Grenier, Richard, San Jose, CA California 95134 (US); Krikelis, Anargyros, San Jose, CA California 95134 (US)
(74) Representative: Hermann, Felix

(56) References cited:
- US-A1- 2009 150 604
- US-B1- 7 120 731
- US-B1- 7 185 172

## Description

### TECHNICAL FIELD

The present disclosure relates generally to programmable hardware and more specifically to an integrated search engine for hardware processors.

### BACKGROUND

Hardware devices generally require data in order to perform different functions. For example the controller of a network router requires data on incoming binary IP addresses in order to quickly route packets. The controller must access the stored data in a memory and return the correct port for corresponding IP address in order to route the packet. Thus, hardware devices require access to memory that stores the data and must have the ability to quickly run a search to discover the address of the desired data. The speed of operating hardware devices is partially dependent on the speed required to find and then access needed data in memory structures.

Generally, standard memory structures (i.e. SRAM/DRAM) are used to store data for programmable devices. Finding data in a standard memory structure requires presenting an address and accessing the requested address for stored data. A conventional read takes a memory address location as an input and returns the cell contents at those addresses. However, if the address is not known, an algorithm must be employed to identify and return the memory location that stores content that matches the search criteria. This process typically involves running a search algorithm to sift through the content stored in the memory to find the desired data.

For example, a common implementation of algorithmic search engines is based on the use of a "hash table" to create an associative array that matches search keys to stored values. A hash function is used to compute an index into an array of categories (buckets) from which the correct match value can be found. Ideally the hash function will assign each key to a unique bucket, but this situation is rarely achievable in practice (typically some keys will hash to the same bucket). Instead, most hash table designs assume that hash collisions (different keys assigned to the same bucket) will occur and must be accommodated in some way.

In a hash table, the average cost for each look-up is independent of the number of elements stored in the table. Hash tables may be more efficient than search trees for some applications such as associative arrays, database indexing and caches. A basic requirement is that the function should provide a uniform distribution of hash values. A non-uniform distribution increases the number of collisions and the cost of resolving them. However, regardless of distribution in the hash table, a search process requires additional clock cycles to find the desired content.

Certain memories employ circuit based search engines based on content addressable memory (CAM). Content Addressable Memory (CAM) allows the input of a search word (e.g., a binary IP address) and the search of the entire memory in a single cycle operation returning one (or more) matches to the search word. Unlike traditional memories where an address is presented to a memory structure and the content of the memory is returned, in CAM designs, a "key" describing a search criteria is presented to a memory structure and the address of the location that has content that matches the key is returned. Special memory cells are used to implement CAM designs where the data is stored allow the search of the memory to occur over a single clock cycle.

Speeding search time by using CAM type circuits involves using specialized integrated circuits for memory searching. The memory array also requires additional dedicated comparison circuitry to allow the simultaneous search and match indications from all cells in the array. However, such CAM based integrated circuits are more complex than a normal RAM and associated search engine and must typically be connected between the memory and the hardware processing device. Thus, the distance between the search integrated circuit and the memory increases the latency time to retrieve the requested data.

Further, such external search specialized chips are currently expensive with limited suppliers. Further, such devices consume a relatively large amount of power. For example, the largest current search devices consume up to 120W at the fastest search rates. The input output interface between the hardware and the memory must be relatively long due to the placement of the memory chip on the printed circuit board in relation to the processing chip. This increases capacitive load that requires higher voltages at higher currents to overcome. The use of a separate TCAM memory also consumes a substantial number of input/output ports as well as requiring large real estate on the printed circuit board.

US 7,185,172 B1 relates to an integrated circuit chip. The integrated circuit chip includes a search engine including a content addressable memory (CAM) configured to produce CAM indices responsive to search instructions provided to the search engine. The search engine further includes an index translation circuit operatively coupled to the CAM and configured to provide translation of the CAM indices to another memory space, such as from an absolute index space associated with the CAM to a memory space associated with a database within the CAM or to a memory space of a device external to the chip, such as a command source or external SRAM.

### SUMMARY

One example is a hardware device having an integrated search engine that employs content addressable memory. The hardware device is on the same die as an integrated ternary content addressable memory (TCAM) search engine and TCAM array to minimize power consumption and latency in search requests for data stored in the TCAM array. Another example is a separate memory die having a TCAM array with a search engine having a low power interface connected to a hardware processing die. Another example is a processing die having parallel TCAM search engines and arrays in column areas in close proximity to soft programmable hardware areas. The object of the invention is solved by the features of the independent claims. Further embodiments are the subject-matter of the dependent claims.

Additional aspects will be apparent to those of ordinary skill in the art in view of the detailed description of various embodiments, which is made with reference to the drawings, a brief description of which is provided below.

### BRIEF DESCRIPTION OF THE DRAWINGS

The foregoing and other advantages will become apparent upon reading the following detailed description and upon reference to the drawings.
FIG. 1 is a block diagram of a processing system on a die with illustrated examples of the interconnect between disparate logic regions and device I/O;
FIG. 2 is a flow diagram of an example hardware processing device requesting a search for data stored in an integrated TCAM array;
FIG. 3 is a block diagram of the components of an example hardware processing die with one or more integrated TCAM search engines;
FIG. 4 is a block diagram of the integrated TCAM search engine and TCAM array on the die in FIG. 3;
FIG. 5A illustrates a table showing example partitions of a TCAM based memory array.
FIG. 5B illustrates a table of multiple example dual-TCAM combinations, each with half of the capacity of an original TCAM;
FIG. 6 is a block diagram of an example hardware system having an integrated search engine on a separate on die chip in proximity to a hardware processing die;
FIG. 7 is a block diagram of the search engine die chip in FIG. 6; and
FIG. 8 is a block diagram of an example hardware processing system die with parallel TCAM search engines embedded within columns between programmable hardware areas.

While the invention is susceptible to various modifications and alternative forms, specific examples have been shown in the drawings and will be described in detail herein. It should be understood, however, that the invention is not intended to be limited to the particular forms disclosed.

### DETAILED DESCRIPTION

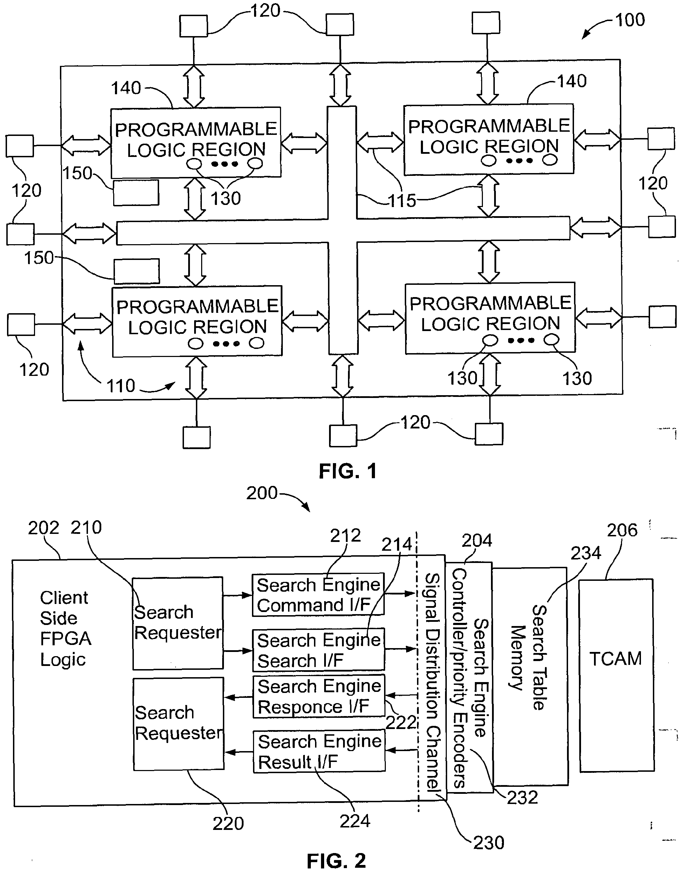

An illustrative example of a computing system that includes data exchange in an integrated circuit component die is a programmable logic device (PLD) 100 in accordance with an embodiment is shown in FIG. 1. The programmable logic device 100 has input/output circuitry 110 for driving signals off of device 100 and for receiving signals from other devices via input/output pins 120. Interconnection resources 115 such as global and local vertical and horizontal conductive lines and buses may be used to route signals on device 100.

Input/output circuitry 110 includes conventional input/output circuitry, serial data transceiver circuitry, differential receiver and transmitter circuitry, or other circuitry used to connect one integrated circuit to another integrated circuit.

Interconnection resources 115 include conductive lines and programmable connections between respective conductive lines and are therefore sometimes referred to as programmable interconnects 115.

Programmable logic region 140 may include programmable components such as digital signal processing circuitry, storage circuitry, arithmetic circuitry, or other combinational and sequential logic circuitry such as configurable register circuitry. As an example, the configurable register circuitry may operate as a conventional register. Alternatively, the configurable register circuitry may operate as a register with error detection and error correction capabilities.

The programmable logic region 140 may be configured to perform a custom logic function. The programmable logic region 140 may also include specialized blocks that perform a given application or function and have limited configurability. For example, the programmable logic region 140 may include specialized blocks such as configurable storage blocks, configurable processing blocks, programmable phase-locked loop circuitry, programmable delay-locked loop circuitry, or other specialized blocks with possibly limited configurability. The programmable interconnects 115 may also be considered to be a type of programmable logic region 140.

Programmable logic device 100 contains programmable memory elements 130. Memory elements 130 can be loaded with configuration data (also called programming data) using pins 120 and input/output circuitry 110. Once loaded, the memory elements each provide a corresponding static control signal that controls the operation of an associated logic component in programmable logic region 140. In a typical scenario, the outputs of the loaded memory elements 130 are applied to the gates of metal-oxide-semiconductor transistors in programmable logic region 140 to turn certain transistors on or off and thereby configure the logic in programmable logic region 140 and routing paths. Programmable logic circuit elements that may be controlled in this way include parts of multiplexers (e.g., multiplexers used for forming routing paths in programmable interconnects 115), look-up tables, logic arrays, AND, OR, NAND, and NOR logic gates, pass gates, etc.

Memory elements 130 may use any suitable volatile and/or non-volatile memory structures such as random-access-memory (RAM) cells, fuses, antifuses, programmable read-only-memory memory cells, mask-programmed and laser-programmed structures, combinations of these structures, etc. Because memory elements 130 are loaded with configuration data during programming, memory elements 130 are sometimes referred to as configuration memory, configuration RAM (CRAM), or programmable memory elements.

The circuitry of device 100 may be organized using any suitable architecture. As an example, the logic of programmable logic device 100 may be organized in a series of rows and columns of larger programmable logic regions each of which contains multiple smaller logic regions. The smaller regions may be, for example, regions of logic that are sometimes referred to as logic elements (LEs), each containing a look-up table, one or more registers, and programmable multiplexer circuitry. The smaller regions may also be, for example, regions of logic that are sometimes referred to as adaptive logic modules (ALMs), configurable logic blocks (CLBs), slice, half-slice, etc. Each adaptive logic module may include a pair of adders, a pair of associated registers and a look-up table or other block of shared combinational logic (i.e., resources from a pair of LEs-sometimes referred to as adaptive logic elements or ALEs in this context). The larger regions may be, for example, logic array blocks (LABs) or logic clusters of regions of logic containing for example multiple logic elements or multiple ALMs.

During device programming, configuration data is loaded into device 100 that configures the programmable logic regions 140 so that their logic resources perform desired logic functions. For example, the configuration data may configure a portion of the configurable register circuitry to operate as a conventional register. If desired, the configuration data may configure some of the configurable register circuitry to operate as a register with error detection and error correction capabilities.

As will be explained below, the device 100 also includes a content addressable memory region 150 for rapid access to data stored in the memory region 150 via a search engine that is part of the memory region 150. The embedded search engine logic in this example uses content accessible memory methods as will be described below to allow rapid data searches and minimize power consumption and latency in contrast to traditional external search engine devices.

FIG. 2 is a block diagram of a search process for an integrated processing system 200. The integrated processing system 200 includes a hardware die 202 (which is logically equivalent to the logic devices on the device 100 in FIG. 1). In this example, the hardware die 202 is based on programmable hardware such as an FPGA. The programmable hardware die 202 is coupled to a search engine 204 and a content addressable memory 206. The hardware die 202 includes a search requestor 210 that interfaces with a search engine command interface 212 and a search engine search interface 214, both coupled to the search engine 204. In this example, the search requestor 210 reflects the logic responsible for dispatching a search request from a memory, which in this case is the content addressable memory 206. The search requestor 210 dispatches a search command and the search engine command interface 212 dispatches a key associated with the data to be searched for. A search consumer 220 captures the search response and result from a search engine response interface 222 through the search engine result interface 224, both coupled to the search engine 204. In this example, the search consumer 220 is any hardware logic that processes data from a memory.

The search engine 204 includes a signal distribution channel 230 that is coupled to a search engine controller 232. The search engine controller 232 in this example is operative to perform a tertiary content addressable memory (TCAM) search that accesses a search table memory 234. As is understood, Ternary CAM (TCAM) refers to designs that use memory able to store and query data using three different input values: 0, 1 and X. The "X" input, which often is referred to as "don't care" or "wildcard" state enables TCAMs to perform broader searches based on partial pattern matching. The controller 232 may also be configured to perform an algorithmic based search in relation to conventional SRAM or DRAM. In this example, the search engine 204 is tightly coupled to the FPGA core in the example hardware core die 202 as an embedded component on the die or may be loosely closely coupled on a separate die directly next to the core die 202.

The search engine controller 232 may be based on content addressable memory searching in order to perform searches in a single clock cycle. A binary content addressable memory (BCAM) refers to designs that use memory able to store and query data using two different input values: 0 and 1. BCAM implementations are commonly used in networking equipment such as high-performance switches to expedite port-address look-up and to reduce latency in packet forwarding and address control list searches. Thus, the controller 232 may use BCAM when the hardware die 202 is used for such functions or similar functions.

In this example, the search engine controller 232 is based on ternary content addressable memory (TCAM) searching that refers to designs that use memory able to store and query data using three different input values: 0, 1 and X. The lowest matching address content is returned first in response to a search returning multiple addresses. TCAM implementations are commonly used in networking equipment such as high-performance routers and switches to expedite route look-up and to reduce latency in packet forwarding and address control list searches.

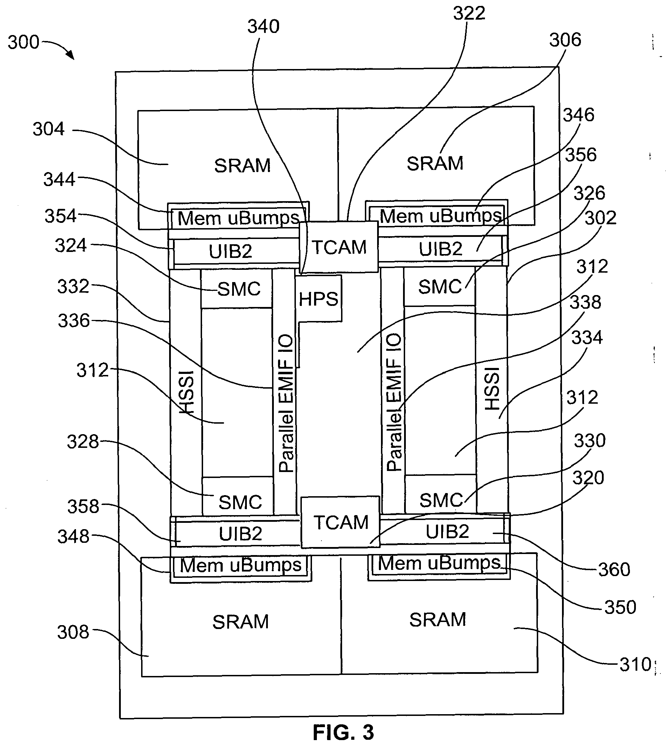

FIG. 3 shows a die layout of components of a programmable hardware device 300 that has embedded search capabilities. The hardware device 300 has a substrate that is divided into different dies including a processing hardware die 302 and four SRAM dies 304, 306, 308 and 310. The hardware processing die 302 in this example is an FPGA based die and also includes different logic fabric areas 312. The die 302 also includes two TCAM modules 320 and 322 that each include a TCAM array and a TCAM search engine to manage searches for data stored in the TCAM array. The search engines of the TCAM modules 320 and 322 may also include additional search functionality for conventional algorithmic searches of data stored on the standard SRAM dies 304, 306, 308 and 310.

The data from the standard SRAM dies 304, 306, 308 and 310 is managed by respective memory controllers 324, 326, 328 and 330. The memory controllers 324, 326, 328 and 330 distribute data to and from the memories 304, 306, 308 and 310. The high speed serial interfaces 332 and 334 moves data to and from the die 302. Separate memory controllers also distribute data between the memories 304, 306, 308 and 310 and the fabric logic areas 312 through parallel external memory input/output busses 336 and 338. An optional hardened processor system 340 may be included.

The hardware processing die area 302 includes four microbump based memory interfaces 344, 346, 348 and 350 that are coupled to the respective memory dies 304, 306, 308 and 310. The microbump memory interfaces 344, 346, 348 and 350 are connected to respective utility integration buses 354, 356, 358 and 360. The respective memory controllers 324, 326, 328 and 330 are coupled to the utility integration busses 354, 356, 358 and 360 to receive and transmit write and read data from and to the memories 304, 306, 308 and 310.

The on die eTCAM modules 320 and 322 enhance the functionality of the base hardware device die 302 such as a FPGA device by providing fast, low-power, low-cost search capability for applications such as networking, pattern-recognition, search analytics, and compute-storage.

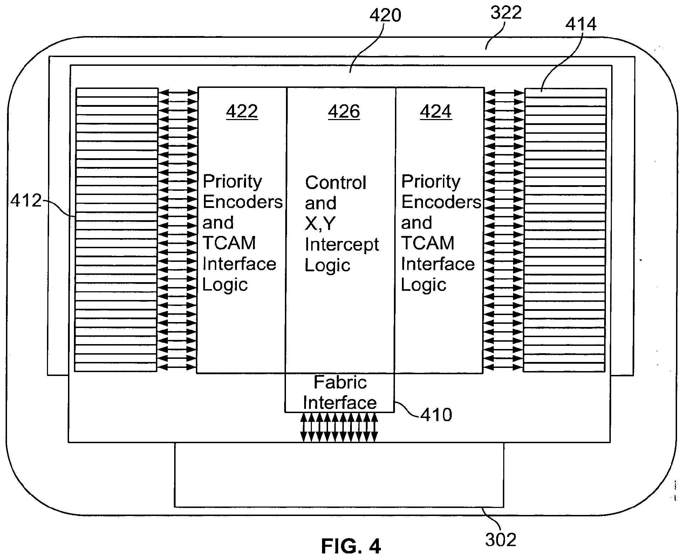

FIG. 4 is a detailed block diagram of an on board arrangement of the TCAM module 322 in FIG. 3 in the FPGA architecture such as that in the system 300. The example TCAM module 322 is coupled to the FPGA logic 402 by a fabric interface 410. The TCAM module 322 includes two TCAM arrays 412 and 414 that are used to store data that may be requested by the logic 302 in FIG. 3. Each of the TCAM arrays 412 and 414 in this example has 32 512 x 80 arrays for a total of 64 512 x 80 arrays in this example. Of course, other sizes of arrays may be used. In this example, there are two TCAM arrays 412 and 414 allow concurrent search of a memory. The TCAM search engine includes a hard control logic area 420. The control logic area 420 constitutes the TCAM search engine and includes interface logic areas 422 and 424 and control and X, Y intercept logic 426.

The interface logic is controlled by the control and intercept logic 426 that accesses the interface areas 422 and 424 to provide search key data to the TCAM arrays 412 and 414 and to receive search data results from each array. The search key is simultaneously compared in all of the elements of the TCAM arrays 412 and 414 and data associated with the desired key is returned to the logic modules 422 and 424.

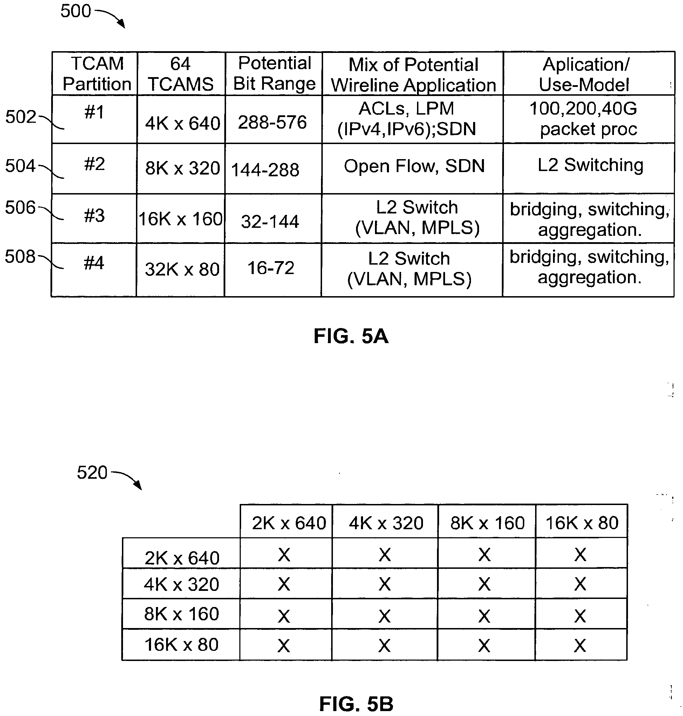

As will be explained, multiple independent TCAM instances may coexist within a given FPGA die, as indicated with modules 320 and 322. Furthermore, it should be possible to partition each TCAM instance into one of several partitions of varying preconfigured widths and/or depths. FIG. 5A shows a table 500 with an example partition configuration for a single TCAM instance having four typically useful partitions. A first entry 502 shows a first partition of 4K x 640 with a unique bit range of 288-576. Example applications include access control lists (ACLs), longest prefix match (LPM), Internet Protocol versions 4 or 6 or software-defined network (SDN) for wireline applications. The application use model allows packet processing with offered traffic loads of 100, 200 or 400Gbit/sec. A second entry 504 shows a second partition of 8K x 320 with a typically useful range of 144-288. The second partition may be used for potential wireline applications including Openflow software defined networking. Other application use models may include configuration of hardware to facilitate the mapping of physical port addresses to Layer 2 MAC addresses.

A third entry 506 shows a third partition of 16K x 160 with a typically useful bit range of 32-144. A fourth entry 508 shows a fourth partition of 32K x 80 with a typically useful bit range of 16-72. Both the third and fourth example partitions may be used for Layer 2 switches for both virtual local area networks (VLAN) and multi-protocol label switching (MPLS). The uses may therefore include bridging, switching and aggregation.

An example eTCAM array instance is an ordered array of "N" TCAM IP blocks, each "M" bits wide (a column) by N rows deep (e.g., 512x80), and includes integrated priority encoder logic for the entire array. Thus, the overall array size may be Y which is M x N. In another example, one full-sized eTCAM array may be partitioned into multiple eTCAM arrays, each with half of the capacity. For example, there may be a single TCAM array instance with NK TCAM IP blocks, each with Y array elements. However, more single TCAM array instances such as 2NK TCAM IP blocks could be created with smaller (Y/2) array elements. This may be further divided into further multiple eTCAM arrays, each with half the capacity of the larger eTCAM arrays. It is understood by those familiar with the art that each additional partition would require an appropriate volume of additional input/output interface, even though each partition may offer half of the capacity.

For example, as shown in a table 520 in FIG. 5B, a 4K x 640 full-sized singular eTCAM instance may be allocated in different configurations having multiple N TCAM IP blocks but with smaller arrays. Table 520 shows a series of potential partitions including 2K TCAM IP blocks of a 640 element array, 4K TCAM IP blocks of a 320 element array, 8K TCAM IP blocks of a 160 element array and 16K TCAM IP blocks of an 80 element array. The 4Kx640 full-sized singular eTCAM may be optionally partitioned as any two of the combinations in the table 520.

As will be explained below, the TCAM engine may be instantiated on-die, or else externally off-die (in package) through a dedicated chip-to-chip interface. A single eTCAM may be configured such that multiple eTCAMs have a unique search array. For example, one TCAM module such as the TCAM module 320 in FIG. 3 may be configured as a 2K x 640 array and a 4K x 320 array, while the other TCAM module 322 may be configured as a 4K x 320 array and an 8K x 160 array. Alternatively, multiple eTCAM instances may be logically concatenated as one singular eTCAM of the aggregate total capacity, yet each with the ability for concurrent independent search.

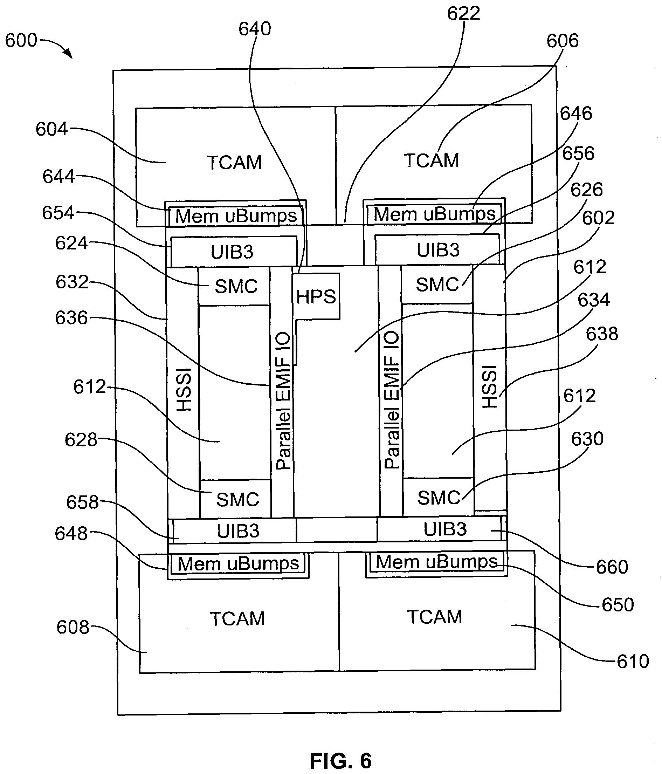

FIG. 6 is a block diagram of a multi-die system 600 that includes a hardware processing die 602 that may be a FPGA and a separate set of content addressable memory modules 604, 606, 608 and 610 in proximity to the multi-die system 600. In this example, the memory modules 604, 606, 608 and 610 include TCAM arrays and a TCAM search engine. The die 602 includes logic fabric areas 612. The memory controllers 624, 626, 628 and 630 distribute data between separate memories (not shown) and the logic areas 612 via parallel external memory input/output busses 632 and 634. The high speed serial interfaces 636 and 638 moves data to and from the die 602. An optional hardened processor system is included.

The hardware processing die 602 includes four microbump based memory interfaces 644, 646, 648 and 650 that are coupled to the respective TCAM memory modules 604, 606, 608 and 610. The microbump memory interfaces 644, 646, 648 and 650 allow connection of the TCAM memory modules 604, 606, 608 and 610 to the devices on the die 602 via respective low power utility integration buses 654, 656, 658 and 660.

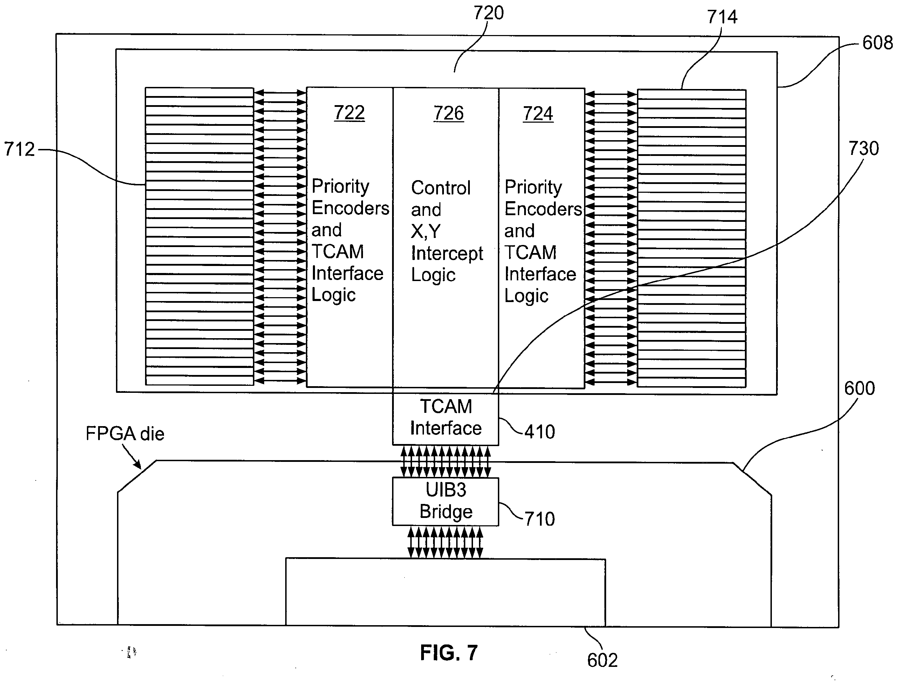

FIG. 7 is a block diagram illustrating the logical view and floorplan for an example TCAM module 610 in FIG 6, along with a bridge interface 710 to the main processing die 600. The example TCAM memory module die 608 is coupled to the hardware logic 602 by a fabric interface 710. The fabric interface 710 is a hard-IP Bridge and may be JEDEC 235 compliant for example (e.g., High Bandwidth Memory, HBM). The bridge fabric interface 710 in this example consumes less input/output power per bit and drives on low power with reduced current to minimize power consumption of the use of the memory module die 608. This is possible due to the reduced capacitance of short reach wires across the bridge interface 710.

The memory module die 608 includes two TCAM arrays 712 and 714 that are used to store data that may be accessed by searches performed by the search engine. Each of the TCAM arrays 712 and 714 in this example has 32 512 x 80 arrays. In this example, the two TCAM arrays 712 and 714 allow concurrent search of the respective data contents. The TCAM search engine includes a hard control logic area 720. The control logic area 720 includes interface logic areas 722 and 724 and control and X, Y intercept logic 726.

The interface logic is controlled by the control and intercept logic 726 that accesses the interface areas 722 and 724 to provide received search keys to the TCAM arrays 712 and 714, and to acquire search hit responses and resultant hit data from the TCAM arrays 712 and 714. The UIB bridge 710 acts as an interface between the generic fabric logic 600, which embodies the client-side search logic 602, and the TCAM interface 730.

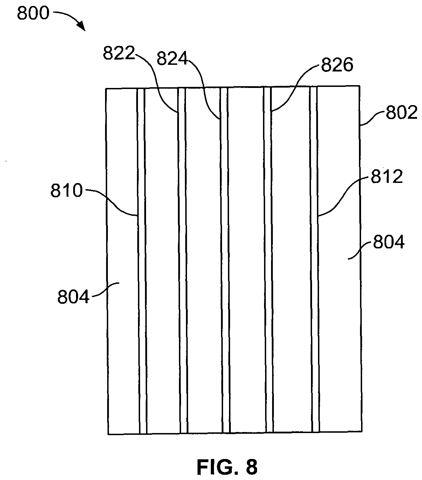

FIG. 8 is a block diagram of a die based processing system 800 that includes parallel hard IP circuit column areas that include CAM search engines. The die based processing system 800 has programmable components on a die 802. The die 802 includes soft fabric areas 804 that contain programmable hardware such as FPGA computational elements or other hardware processor circuits. Certain parallel columnar areas 810 and 812 include specific function hardware such as memory elements, digital signal processors, ALU elements, etc. In this example, the specific function hardware is arranged in columnar areas across the die 802. A user may program the hardware processor circuits in the soft fabric areas 804 via interconnections to perform different functions. Such functions may use the specialized functions of the parallel hardware columnar areas that are in proximity to the soft fabric areas 804.

In one example, the parallel hardware columnar areas may also include content addressable memory modules in columnar areas 822, 824 and 826 in this example. The memory modules 822, 824, and 826 may include one or multiple TCAM arrays and related search engine hard-IP instances within one or more hard-IP columns. The TCAM search engine allows search of data in the TCAM array as explained above. In this example, the TCAM memory array and TCAM search engine are arranged in the column areas similar to those for the other specific function hardware, allowing a tightly coupled interface with the soft fabric areas 804 that may require memory search functionality.

The different search engines in proximity with the hardware processing devices in the above examples enables multiple and variable types of configurable search engine mechanisms to coexist within a hardware processor core. For example, different memory searches including binary CAM, ternary CAM, and hash-based algorithms may be used for data storage based on search application requirements. Thus, column-based integration of multiple distributed search engines and content addressable memory such as the memory modules 822, 824 and 826 enables low-latency (close-proximity) access to core client-side search logic.

The multiple eTCAM modules enable multiple independent, concurrent searches. For example, each TCAM module 320 and 322 in FIG. 3 may have a unique partition. Both of the TCAM modules 320 and 322 could be used as separate ingress/egress search engines. Another alternative is combining the two TCAM modules 320 and 322 as one logical TCAM of twice the capacity of the individual TCAM modules 320 and 322.

The embedded or in-package search engines in FIGs. 3 and 6 require substantially reduced power consumption (per search), preserve FPGA I/O, and reduce printed circuit board congestion and routing complexity. As explained above, the embedded search engines offer the advantages of integrated single cycle searches while minimizing latency. Configurable eTCAM enables multiple user-defined search configurations of varying widths, depths, and operating frequencies depending on the application and look-up requirement.

According to an Alternate Embodiment 1, a processing system comprises: a hardware processor die including a memory interface; and a memory die in proximity to the hardware processor die, the memory die including a content addressable memory array, a processor interface and a search engine receiving requests for data content stored in the content addressable memory array; wherein the memory interface operates at low power and low voltage.

The processing system of Alternate Embodiment 1, wherein the content addressable memory may be partitioned with a preconfigured width and depth.

The processing system of Alternate Embodiment 1, wherein the content addressable memory array is a binary content addressable memory.

The processing system of Alternate Embodiment 1, wherein the content addressable memory array is a ternary content addressable memory.

The processing system of Alternate Embodiment 1, wherein the memory die includes a RAM based memory, and wherein the search engine performs an algorithmic search for data content stored in the RAM based memory in response to a request from the hardware processor die.

The processing system of Alternate Embodiment 1, wherein the content addressable memory array is partitioned into different virtual memories.

The processing system of Alternate Embodiment 1, wherein the content addressable memory array is combinable with another content addressable memory array to form a virtual content addressable memory array.

According to an Alternate Embodiment 2, an integrated circuit die, comprises: a soft fabric area including a hardware processor circuit; a first columnar area adjacent to the soft fabric area, the first columnar area including a search engine receiving search requests for data content and a content addressable memory coupled to the search engine, the content addressable memory being searchable by the search engine in response to request for data content from the hardware processor circuit; and an interconnection between the search engine and the hardware processor circuit.

According to an Alternate Embodiment 3, the integrated circuit die of Alternate Embodiment 2, further comprises a second columnar area parallel to the first columnar area, the second columnar area including a fixed functional hardware circuit.

The integrated circuit die of Alternate Embodiment 3, wherein the fixed functional hardware circuit is one of a group of memory elements, digital signal processor elements, or arithmetic logic unit elements.

The integrated circuit die of Alternate Embodiment 2, wherein the content addressable memory array is a ternary content addressable memory.

While the present principles have been described with reference to one or more particular examples, those skilled in the art will recognize that many changes can be made thereto.

## Claims

1. An FPGA-based integrated circuit die (202, 302) **characterized by:**
logic fabric areas (312) including hardware processor circuits (210, 220); and
a content addressable memory module (322) comprising:
fabric interface (410) coupled to logic (402) in said the FPGA-based logic fabric areas (312) to provide an interconnection (212, 214, 222, 224) between a search engine (204) and at least one of the hardware processor circuits;
a first and a second content addressable memory array (206; 412, 414) for storing data;
control logic area (420) constituting the search engine (204) and for managing searches for data stored in the first and a second content addressable memory array (206; 412, 414), wherein the control logic area (420) includes:
a first and a second interface logic area (422, 424) for providing search key data to the first and a second content addressable memory array (206; 412, 414); and
intercept logic (426) for controlling the a first and a second interface logic area (422, 424);
wherein the content addressable memory module (322) is searchable by the search engine (204) in response to request for data content from the at least one (210) of the hardware processor circuits.

2. The integrated circuit die (202, 302) of claim 1, wherein the content addressable memory module (322) is partitioned with a preconfigured width and depth.

3. The integrated circuit die (202, 302) of claim 1 or 2, wherein the content addressable memory module (322) provides a binary content addressable memory.

4. The integrated circuit die (202, 302) of claim 1 or 2, wherein the content addressable memory module (322) provides a ternary content addressable memory.

5. The integrated circuit die (202, 302) of one of claims 1 to 4, wherein the content addressable memory module (322) is partitioned into different virtual memories.

6. The integrated circuit die (202, 302) of one of claims 1 to 5, further comprising another content addressable memory module (320) that is combined with the content addressable memory module (322) to form a virtual content addressable memory.

## Patentansprüche

1. FPGA-basierte integrierte Schaltung (202, 302), **gekennzeichnet durch**:
Logik-Fabric-Bereiche (312), einschließlich Hardware-Prozessorschaltungen (210, 220); und
ein inhaltsadressierbares Speichermodul (322), umfassend:
eine Fabric-Schnittstelle (410), die mit der Logik (402) in den FPGA-basierten Logik-Fabric-Bereichen (312) gekoppelt ist, um eine Verbindung (212, 214, 222, 224) zwischen einer Suchmaschine (204) und mindestens einer der Hardware-Prozessorschaltungen bereitzustellen;
ein erstes und ein zweites inhaltsadressierbares Speicherarray (206, 412, 414) zum Speichern von Daten;
Steuerlogik-Bereich (420), der die Suchmaschine (204) darstellt und zum Verwalten von Suchen nach Daten dient, die in dem ersten und einem zweiten inhaltsadressierbaren Speicherarray (206, 412, 414) gespeichert sind, wobei der Steuerlogik-Bereich (420) enthält:
einen ersten und einen zweiten Schnittstellenlogik-Bereich (422, 424) zum Bereitstellen von Suchschlüsseldaten für das erste und ein zweites inhaltsadressierbares Speicherarray (206, 412, 414); und
Abfanglogik (426) zum Steuern des ersten und des zweiten Schnittstellenlogik-Bereichs (422, 424);
wobei das inhaltsadressierbare Speichermodul (322) von der Suchmaschine (204) in Reaktion auf eine Anforderung des Dateninhalts von der mindestens einen (210) der Hardware-Prozessorschaltungen durchsuchbar ist.

2. Integrierter Schaltungschip (202, 302) nach Anspruch 1, wobei das inhaltsadressierbare Speichermodul (322) mit einer vorkonfigurierten Breite und Tiefe partitioniert ist.

3. Integrierter Schaltungschip (202, 302) nach Anspruch 1 oder 2, wobei das inhaltsadressierbare Speichermodul (322) einen binären inhaltsadressierbaren Speicher bereitstellt.

4. Integrierter Schaltungschip (202, 302) nach Anspruch 1 oder 2, wobei das inhaltsadressierbare Speichermodul (322) einen ternären inhaltsadressierbaren Speicher bereitstellt.

5. Integrierter Schaltungschip (202, 302) nach einem der Ansprüche 1 bis 4, wobei das inhaltsadressierbare Speichermodul (322) in verschiedene virtuelle Speicher partitioniert ist.

6. Integrierter Schaltungschip (202, 302) nach einem der Ansprüche 1 bis 5, ferner umfassend ein anderes inhaltsadressierbares Speichermodul (320), das mit dem inhaltsadressierbaren Speichermodul (322) kombiniert wird, um einen virtuellen inhaltsadressierbaren Speicher zu bilden.

## Revendications

1. Pastille (202, 302) de circuit intégré basée sur un FPGA, **caractérisée par** :
des zones (312) de maillage de logique comprenant des circuits (210, 220) de processeur matériel ; et
un module (322) de mémoire adressable par le contenu comportant :
une interface (410) de maillage couplée à une logique (402) dans lesdites zones (312) de maillage de logique basées sur le FPGA pour assurer une interconnexion (212, 214, 222, 224) entre un moteur (204) de recherche et au moins un des circuits de processeur matériel ;
un premier et un deuxième réseau (206 ; 412, 414) de mémoire adressable par le contenu servant à stocker des données ;
une zone (420) de logique de commande constituant le moteur (204) de recherche et servant à gérer des recherches de données stockées dans le premier et le deuxième réseau (206 ; 412, 414) de mémoire adressable par le contenu, la zone (420) de logique de commande comprenant :
une première et une deuxième zone (422, 424) de logique d'interface servant à fournir des données de clés de recherche au premier et au deuxième réseau (206 ; 412, 414) de mémoire adressable par le contenu ; et
une logique (426) d'interception servant à commander la première et la deuxième zone (422, 424) de logique d'interface ;
le module (322) de mémoire adressable par le contenu pouvant être exploré par le moteur (204) de recherche en réponse à une demande de contenu de données provenant du ou des circuits (210) parmi les circuits de processeur matériel.

2. Pastille (202, 302) de circuit intégré selon la revendication 1, le module (322) de mémoire adressable par le contenu étant partitionné avec une largeur et une profondeur préconfigurées.

3. Pastille (202, 302) de circuit intégré selon la revendication 1 ou 2, le module (322) de mémoire adressable par le contenu constituant une mémoire binaire adressable par le contenu.

4. Pastille (202, 302) de circuit intégré selon la revendication 1 ou 2, le module (322) de mémoire adressable par le contenu constituant une mémoire ternaire adressable par le contenu.

5. Pastille (202, 302) de circuit intégré selon l'une des revendications 1 à 4, le module (322) de mémoire adressable par le contenu étant partitionné en différentes mémoires virtuelles.

6. Pastille (202, 302) de circuit intégré selon l'une des revendications 1 à 5, comportant en outre un autre module (320) de mémoire adressable par le contenu qui est combiné avec le module (322) de mémoire adressable par le contenu pour former une mémoire virtuelle adressable par le contenu.
